# EUROPÄISCHE PATENTANMELDUNG

(11) **EP 1 087 211 A2**
(43) Veröffentlichungstag der Anmeldung: **28.03.2001**
(21) Anmeldenummer: 00890283.5
(22) Anmeldetag: 18.09.2000
(51) Int. Cl.: G01D 4/00

(54) **Verfahren zur Ermittlung des Energiebezuges**

(30) Priorität: 22.09.1999 AT 162299
(71) Anmelder: Siemens AG Österreich, 1210 Wien (AT)
(72) Erfinder: Fink, Thomas, 1150 Wien (AT)
(74) Vertreter: Matschnig, Franz, Dipl.-Ing.

(57) **Zusammenfassung**

Ein Verfahren zur Ermittlung des Energiebezugs von Verbrauchern, bei welchem die Messdaten von Lastprofilzählern (LPZ) an ein Zählerfernauslesesystem (ZFA) gesandt werden, und sodann in einer Lastprofilverarbeitung (LPV) eine Verknüpfung von Tariffunktionen mit Lastprofilen durchgeführt wird, wobei in der Lastprofilverarbeitung virtuelle, den Lastprofilzählern (LPZ) entsprechende, Zähler (VIZ) eingerichtet werden, auf welchen Energiebezugsvereinbarungen (EBV) abgebildet werden. Auf die virtuellen Zähler (VIZ) werden Tarifierungsverträge (TAV) abgebildet, wobei deren Energiebezugsvereinbarungen (EBV) mit Hilfe einer formalen Vertragsdefinitionssprache abgebildet werden, deren Syntax aus realen Verträgen abgeleitet wird.

## Beschreibung

Die Erfindung bezieht sich auf ein Verfahren zur Ermittlung des Energiebezugs von Verbrauchern, bei welchem die Messdaten einer Mehrzahl von Lastprofilzählern an ein Zählerfernauslesesystem gesandt werden, und sodann in einer Lastprofilverarbeitung eine Verknüpfung von Tariffunktionen mit Lastprofilen durchgeführt wird, wobei in der Lastprofilverarbeitung virtuelle Zähler als persistente Objekte eingerichtet werden, welche in ihren relevanten Eigenschaften den Lastprofilzählern entsprechen, wobei Energiebezugsvereinbarungen auf die virtuellen Zähler abgebildet werden und die Messdaten und die verknüpften Daten für den Zugriff von Klienten, wie einem Verrechnungssystem, zur Verfügung gestellt werden.

Die Erfindung bezieht sich ebenso auf ein System zur Lastprofilverarbeitung mit einer Mehrzahl von Lastprofilzählern, einem Zählerfernauslesesystem und einer diesem nachgeordneten Lastprofilverarbeitung zur Verknüpfung von Tariffunktionen mit Lastprofilen, wobei in der Lastprofilverarbeitung virtuelle Zähler als persistente Objekte einrichtbar und Energiebezugsvereinbarungen auf die virtuellen Zähler abbildbar sind und ein Zugriff von Klienten, wie einem Verrechnungssystem, auf die Messdaten und die verknüpften Daten ermöglicht ist.

Verfahren dieser Art sind bekannt, wobei die Messdaten der Lastprofilzähler beispielsweise über ein Telefonnetz an das Zählerfernauslesesystem und von hier an die Lastprofilverarbeitung gesandt werden können. Eine Lastprofilverarbeitung wird benötigt, um die oft komplizierten Vereinbarungen zwischen einem Energieversorger und seinen Sondervertragskunden bezüglich der Energiebezugstariffierung verrechnen zu können. Bei Vorliegen eines liberalisierten Strommarktes können die Verträge aber auch mit anderen juristischen Personen, beispielsweise den Betreibern des Stromversorgungsnetzes abgeschlossen werden. Die Vertragskomponenten für die Energiebezugstariffierung werden bei bekannten Systemen bzw. Verfahren als Entitäten in Datenbanksystemen abgebildet oder sie sind als statistische Programmstrukturen implementiert. Das bedeutet, dass grundlegende Tariffierungsmöglichkeiten in der Implementierungsphase festgelegt werden, die zur Laufzeit nur schwer oder gar nicht geändert werden können. Bei Einführung neuer Tarifprodukte können sich daher große Verzögerungen ergeben, da unter Umständen auch Programmänderungen erforderlich sind.

Die derzeit bekannten Verfahren wurden noch vor der Strommarktliberalisierung entwickelt und sind auf einen monopolistischen Markt mit langfristiger Tariffierung ausgerichtet. Daraus ergeben sich auch ihre Applikations- und User-Interfaces, die nicht für sich rasch ändernde Vertragsverhältnisse zwischen Energieversorgern/Leitungsbetreibern und ihren Kunden konzipiert waren.

Wenn mehrere Klienten, z.B. eine Statistikabteilung, eine Verrechnungsstelle etc. an die Lastprofilverarbeitung zugreifen sollen, so sind die Datenquellen und -senken derzeit entweder fest vorgegeben oder sie werden bei der Initialisierung parametriert. Die gleichzeitige Bedienung mehrer Klienten durch diese bekannten Systeme ist daher relativ schwierig. Wegen der fehlenden Abstraktionen in den bestehenden Verfahren sind zu deren Betrieb und Wartung auch hoch ausgebildete Spezialisten erforderlich.

Aus der DE 197 20 315 Cl geht ein Verfahren zur Erfassung und/oder Berechnung von abrechnungsrelevanten Verbrauchergrößen hervor, das die Bildung virtueller Tarifmodule vorsieht. Die Tariffierung erfolgt dann über ein solches programmiertes Modul, das über Parameter steuerbar ist. Sind Änderungen gewünscht, so muss man in das laufende Systeme eingreifen, was zu Betriebsunterbrechungen führt.

Erwähnt sei noch, dass die GB 2 292 044 A ein System zur Fernauslesung von Stromzählern beschreibt, bei welchen über Modems und Telefonleitungen die Verbrauchsdaten in digitaler Form an eine Zentrale gesandt werden.

Auch gemäß der US 5 079 715 erfolgt die Übertragung von Strom-, Gas- oder Wasserzählern über Modems und Telefonleitungen. Gegenstand dieses Dokuments ist vor allem eine Datensicherung bei Ausfällen der Versorgungsspannung sowie die Datenspeicherung.

Eine Aufgabe der Erfindung liegt darin, ein Verfahren zu schaffen, mit welchem es möglich ist, die Anforderungen eines liberalisierten Strommarktes bezüglich flexibler und rasch änderbarer Tariffierung abzudecken. Eine optimale Nutzung der Freiheiten bezüglich der Energiebezugstarifgestaltung im liberalisierten Strommarkt durch rasche EDV-mäßige Umsetzung neu kreierter Tarifprodukte soll möglich sein. Änderungen in Vereinbarungen sollen ohne Betriebsunterbrechungen und ohne Heranziehung hochspezialisierten Personals möglich sein.

Diese Aufgabe lässt sich mit einem Verfahren der eingangs genannten Art lösen, bei welchem erfindungsgemäß Tariffierungsverträge auf die virtuellen Zähler abgebildet werden, wobei deren Energiebezugsvereinbarungen auf die virtuellen Zähler mit Hilfe einer formalen Vertragsdefinitionssprache abgebildet werden, deren Syntax aus realen Verträgen abgeleitet wird.

Das Verfahren nach der Erfindung kann wegen seines offenen Konzeptes an Neugliederungen des Elektrizitätsmarktes leicht angepasst werden, was auch für das sogenannte "Unbundling", das ist ein Lösen von oft schwer durchschaubaren Quersubventionen, gilt. Dank der Erfindung werden die komplexen Funktionalitäten des Systems auf die leicht verständliche Ebene der Zähler abstrahiert, wodurch das Systemverständnis bei allen involvierten Personen, wie Verkäufer, Käufer, Benutzer gesteigert werden kann. Unterschiedliche Klienten, z.B. Abteilungen eines Unternehmens, wie Verrechnung, Produktentwicklung, Statistik etc. können das System gleichzeitig nutzen, ohne sich gegenseitig zu beeinflussen und damit die Integrität der Daten zu gefährden, da die Datensenken durch den Klienten festgelegt werden. Eine Einbindung in unterschiedlichste Geschäftsprozesse ist daher möglich. Auch kann die Syntax einer einfachen formalen Sprache von allen Vertragspartnern leicht gelesen, verstanden und rasch erlernt werden und man benötigt keine besonders ausgebildeten Softwarespezialisten.

Bei einer vorteilhaften Variante ist vorgesehen, dass bei der Einrichtung der virtuellen Zähler die Lastprofilzähler unter Verwendung eines Grundparametrisierungsvertrages auf die virtuellen Zähler abgebildet werden, da dadurch die Flexibilität des Verfahrens erhöht wird.

Mit Vorteil kann ein Tariffierungsvertrag eines Verbrauchers und dessen, als Lastprofil abgespeicherter Verbrauch in dem virtuellen Zähler gekapselt werden. Da der virtuelle Zähler als Softwareobjekt generiert wird, von "außen" jedoch wie ein herkömmlicher Lastprofilzähler mit mehreren Tarifregistern erscheint, wird das System zu Lastprofilverarbeitung sehr flexibel und transparent.

Die Aufgabe nach der Erfindung wird auch mit einem System der zu Beginn angegebenen Art gelöst, bei welchem erfindungsgemäß Tariffierungsverträge auf die virtuellen Zähler abbildbar sind wobei zur Abbildung der Energiebezugsvereinbarungen auf die virtuellen Zähler eine formale Vertragsdefinitionssprache vorgesehen ist und die Syntax der Sprache aus realen Verträgen abgeleitet ist.

Die mit diesem System nach der Erfindung erreichbaren Vorteile wurden bereits in Zusammenhang mit dem erfindungsgemäßen Verfahren genannt.

Bei einer vorteilhaften Weiterbildung des erfindungsgemäßen Systems ist vorgesehen, dass bei der Einrichtung der virtuellen Zähler die Lastprofilzähler unter Verwendung eines Grundparametrisierungsvertrages auf die virtuellen Zähler abbildbar sind.

Auch ist es zweckmäßig, wenn ein Tariffierungsvertrag eines Verbrauchers und dessen, als Lastprofil abgespeicherter Verbrauch in den virtuellen Zähler kapselbar sind.

Die Erfindung samt weiteren Vorteilen ist im Folgenden anhand eines Ausführungsbeispieles näher erläutert, das in der Zeichnung veranschaulicht ist. Dabei zeigen
- Fig. 1 in einem vereinfachten Blockschaltbild ein Lastprofilverarbeitungssystem nach der Erfindung,
- Fig. 2 die Abbildung von Energiebezugsvereinbarungen auf einen virtuellen Zähler und
- Fig. 3 die Ablesung eines virtuellen Zählers.

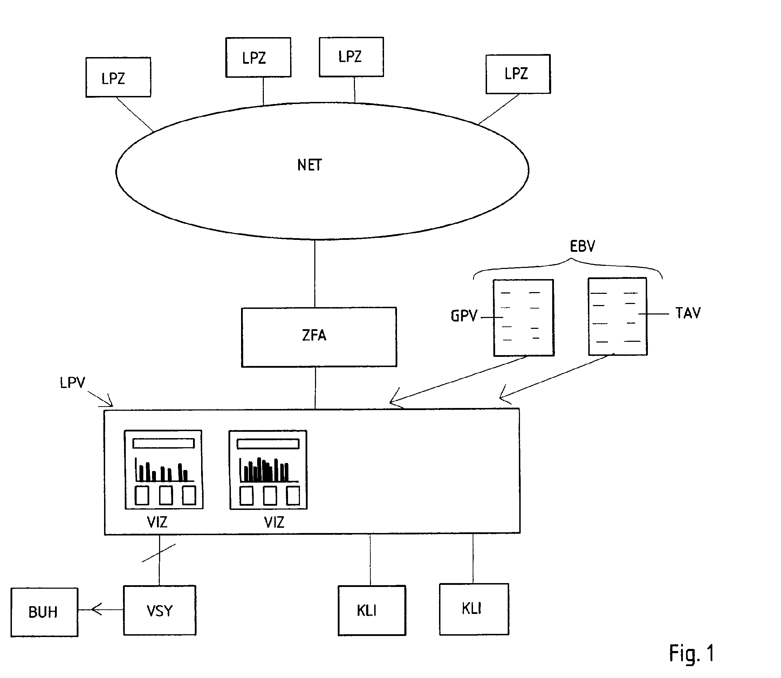

Gemäß Fig. 1 sind bei nicht näher dargestellten Verbrauchern Lastprofilzähler LPZ vorgesehen und deren Daten, z.B. Zählerimpulse werden über ein Netz NET im allgemeinen ein Telefonnetz, drahtgebunden oder über Funkschnittstellen, an ein Zählerfernauslesesystem ZFA gesandt. In diesem Fernauslesesystem liegen die Daten der Zähler abgespeichert vor, wobei eine Lastprofiverarbeitung LPV auf diese Daten zugreifen und die Lastprofile der einzelnen Zähler mit Tariffunktionen verknüpfen kann. Über geeignete Schnittstellen stehen sodann die Messdaten und die verknüpften Daten Klienten zur Verfügung, wie beispielsweise einem Verrechnungssystem VSY, welches sodann die Daten an eine Buchhaltung BUH oder andere Klienten KLI, die in Fig. 1 angedeutet sind, weitergeben kann.

Gemäß der Erfindung werden nun in der Lastprofilverarbeitung LPV virtuelle Zähler VIZ als persistente Objekte eingerichtet. Diese virtuellen Zähler besitzen ein Lastprofil und ein oder mehrere Tarifregister, die durch die Interpretation von Energiebezugsvereinbarungen gebildet werden.

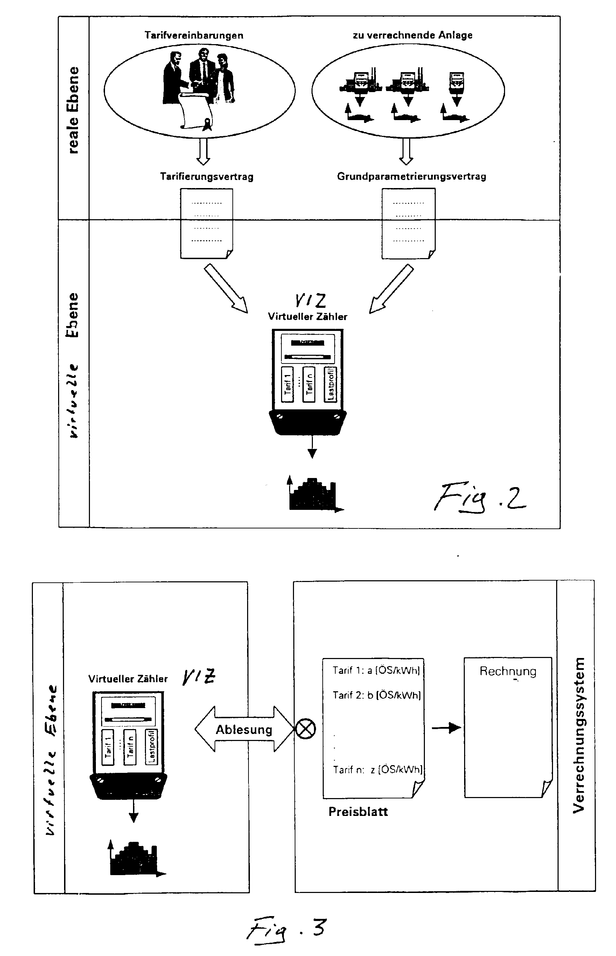

Derartige Energiebezugsvereinbarungen EBV bestehen im allgemeinen aus einem Grundparametrisierungsvertrages GPV sowie aus einem Tariffierungsvertrag TAV, was auch in Fig. 2 schematisch illustriert ist. Es erfolgt somit eine Abbildung der Energiebezugsvereinbarungen EBV auf die virtuellen Zähler VIZ, welche in ihren wesentlichen Eigenschaften vollständig den realen Lastprofilzählern LPZ entsprechen.

Der Grundparametrisierungsvertrag GPV enthält alle Informationen, die für die Abbildung der beim Kunden installierten Lastprofilzähler und seinen zugehörigen virtuellen Zählern benötigt werden. Das sind insbesondere Referenzen auf Lastprofile realer Zähler, die man zur Bildung des Lastprofils der virtuellen Zähler benötigt, mathematische Vorschriften zur Verknüpfung der referenzierten realen Lastprofile zum Lastprofil des virtuellen Zähler, die Periodendauer des Lastprofils des virtuellen Zählers und auch die Zeitzone des virtuellen Zählers.

Im Tariffierungsvertrag TAV hingegen wird festgelegt, wie das im Grundparametrisierungsvertrag GPV befindende Lastprofil des virtuellen Zählers auf die Tarifregister des virtuellen Zählers aufgeteilt wird.

Es werden somit die Vereinbarungen bezüglich der Energiebezugstariffierung eines Kunden und dessen tatsächlicher, als Lastprofil abgespeicherter Verbrauch in einer objektorientierten Komponente gekapselt, die in ihrer Funktionalität und Handhabung einem realen Lastprofilzähler mit Tarifregistern entspricht und folgerichtig als "virtueller Zähler" bezeichnet wird. Ein Vorteil dieser Abstraktion liegt darin, dass für die Verrechnung eines komplexen Sondervertragskunden eine einfache Auslesung seines zugehörigen virtuellen Zähler VIZ genügt. Aus Sicht der Messwertaufbringung wird die Komplexität der schwierig zu behandelnden Sondervertragskunden auf das Niveau einfacher Tarifkunden reduziert.

Die Handhabung des gesamten Verfahren und Systems wird wesentlich dadurch erleichtert, dass zur Abbildung der Energiebezugsvereinbarungen EBV auf die virtuellen Zähler VIZ eine formale Vertragsdefinitionssprache verwendet wird, deren Syntax man aus realen Verträgen ableitet. Für den Informatiker gibt es bei der gegebenen Aufgabenstellung viele Möglichkeiten, eine derartige Sprache zu schaffen, doch wird man sich - wie bereits erwähnt - an bewährte, schriftlich vorliegende Verträge halten. In Nachstehenden wird ein Beispiel für einen Grundparametrisierungsvertrag GBV für einen Zähler, der hier "V-Meter 01" genannt wird, gegeben und im Anschluss daran ein Tariffierungsvertrag, der hier den Namen "Verbund 1" trägt. Aus dem Beispiel sieht der Fachmann wie beispielsweise die Vertragsdefinitionssprache aussehen kann.

### Beispiel:

Ein Kunde möchte für drei Betriebsanlagen eine gemeinsame Rechnung.
Folgende Verrechnung wurde vereinbart:
- Gültigkeit ab 1. 1. 2000.
- Verbrauch aller Anlagen soll gemeinsam gemessen werden.
- Angemeldet Bandenergie wird zu Tarif 1 im HT/NT verrechnet.
- Überschreibungen von mehr als 10 MW oder Unterschreitungen von mehr als 7 MW werden zu Tarif 2 HT/NT verrechnet.
- Ist keine Bandenergie angemeldet, so wird die Energie zu Tarif 3 HT/NT verrechnet.
- HT: Sommer Mo - Fr 6 - 22 Uhr, Sa 6 - 13 Uhr, außer an Feiertagen, Winter täglich von 6 - 22 Uhr.

### Grundparametrierungsvertrag GPV für Zähler "vMeter 01"

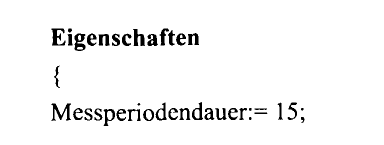

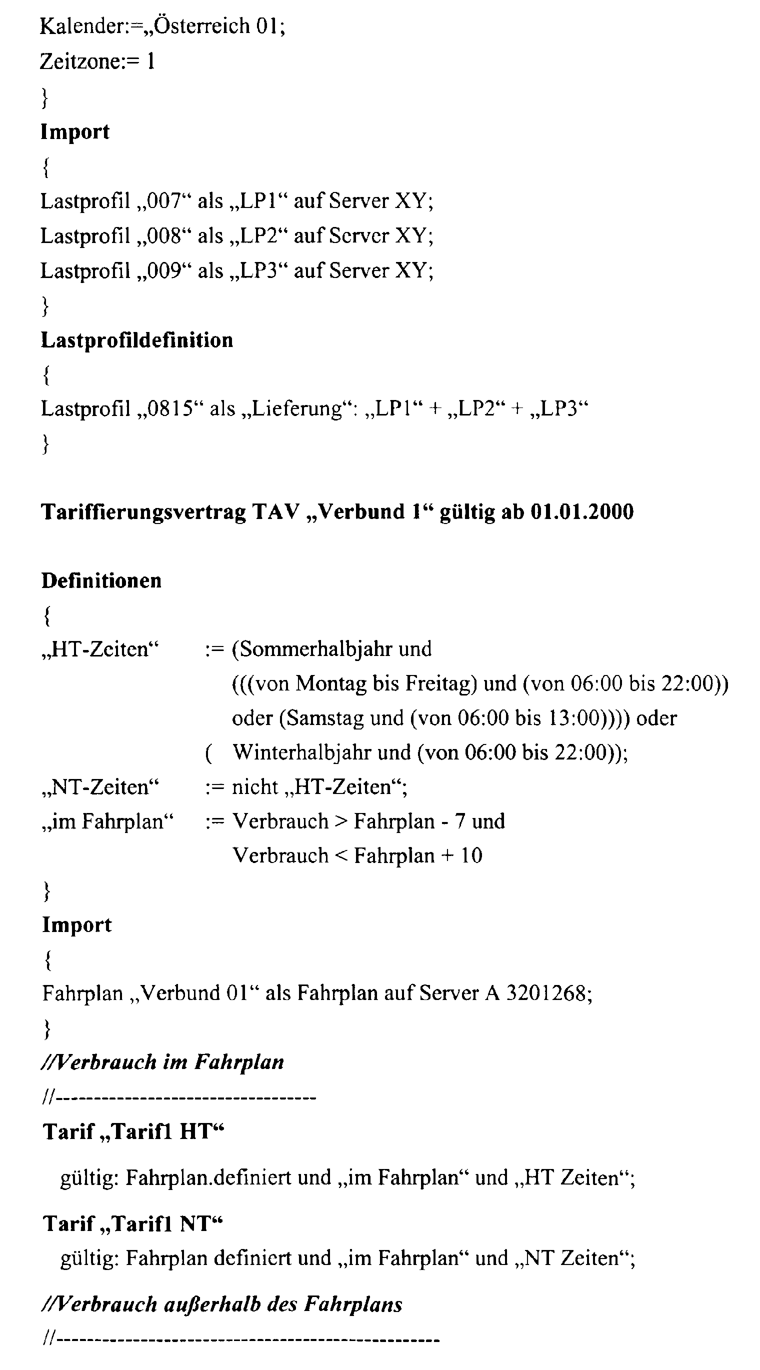

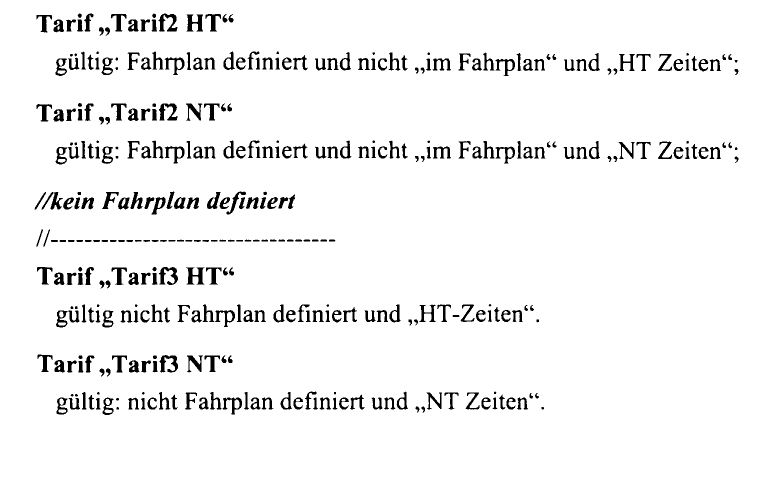

## Patentansprüche

1. Verfahren zur Ermittlung des Energiebezugs von Verbrauchern, bei welchem die Messdaten einer Mehrzahl von Lastprofilzählern (LPZ) an ein Zählerfernauslesesystem (ZFA) gesandt werden, und sodann in einer Lastprofilverarbeitung (LPV) eine Verknüpfung von Tariffunktionen mit Lastprofilen durchgeführt wird, wobei in der Lastprofilverarbeitung virtuelle Zähler (VIZ) als persistente Objekte eingerichtet werden, welche in ihren relevanten Eigenschaften den Lastprofilzählern (LPZ) entsprechen, wobei Energiebezugsvereinbarungen (EBV) auf die virtuellen Zähler abgebildet werden und die Messdaten und die verknüpften Daten für den Zugriff von Klienten (KLI), wie einem Verrechnungssystem (VSY), zur Verfügung gestellt werden,
**dadurch gekennzeichnet, dass**
Tariffierungsverträge (TAV) auf die virtuellen Zähler (VIZ) abgebildet werden, wobei deren Energiebezugsvereinbarungen (EBV) auf die virtuellen Zähler (VIZ) mit Hilfe einer formalen Vertragsdefinitionssprache abgebildet werden, deren Syntax aus realen Verträgen abgeleitet wird.

2. Verfahren nach Anspruch 1, **dadurch gekennzeichnet, dass** bei der Einrichtung der virtuellen Zähler (VIZ) die Lastprofilzähler (LPZ) unter Verwendung eines Grundparametrisierungsvertrages (GPV) auf die virtuellen Zähler abgebildet werden.

3. Verfahren nach Anspruch 1 oder 2, **dadurch gekennzeichnet, dass** ein Tariffierungsvertrag eines Verbrauchers und dessen, als Lastprofil abgespeicherter Verbrauch in dem virtuellen Zähler (VIZ) gekapselt werden.

4. System zur Lastprofilverarbeitung mit einer Mehrzahl von Lastprofilzählern (LPZ), einem Zählerfernauslesesystem (ZFA) und einer diesem nachgeordneten Lastprofilverarbeitung (LPV) zur Verknüpfung von Tariffunktionen mit Lastprofilen, wobei in der Lastprofilverarbeitung (LPV) virtuelle Zähler (VIZ) als persistente Objekte einrichtbar und Energiebezugsvereinbarungen auf die virtuellen Zähler abbildbar sind und ein Zugriff von Klienten (KLI), wie einem Verrechnungssystem, auf die Messdaten und die verknüpften Daten ermöglicht ist, **dadurch gekennzeichnet, dass** Tariffierungsverträge (TAV) auf die virtuellen Zähler abbildbar sind wobei zur Abbildung der Energiebezugsvereinbarungen (EBV) auf die virtuellen Zähler (VIZ) eine formale Vertragsdefinitionssprache vorgesehen ist und die Syntax der Sprache aus realen Verträgen abgeleitet ist.

5. System zur Lastprofilverarbeitung nach Anspruch 4, **dadurch gekennzeichnet, dass** bei der Einrichtung der virtuellen Zähler (VIZ) die Lastprofilzähler (LPZ) unter Verwendung eines Grundparametrisierungsvertrages (GPV) auf die virtuellen Zähler abbildbar sind.

6. System zur Lastprofilverarbeitung nach Anspruch 4 oder 5, **dadurch gekennzeichnet, dass** ein Tariffierungsvertrag eines Verbrauchers und dessen, als Lastprofil abgespeicherter Verbrauch in dem virtuellen Zähler (VIZ) kapselbar ist.
